# EUROPÄISCHE PATENTSCHRIFT

(11) **EP 0 258 840 B1**
(45) Veröffentlichungstag und Bekanntmachung des Hinweises auf die Patenterteilung: **02.11.1994**
(21) Anmeldenummer: 87112559.7
(22) Anmeldetag: 28.08.1987
(51) Int. Cl.: H03M 1/38

(54) **Sukzessives Approximations-Register**
Successive approximation register
Registre à approximation successive

(30) Priorität: 02.09.1986 DE 3629832
(43) Veröffentlichungstag der Anmeldung: 09.03.1988
(73) Patentinhaber: SIEMENS AKTIENGESELLSCHAFT, 80333 München (DE)
(72) Erfinder: Draxelmayr, Dieter, Dipl.-Ing., A-9500 Villach (AT)

(56) Entgegenhaltungen:
- IEE PROCEEDINGS-E: COMPUTERS AND DIGITAL TECHNIQUES, Band 128, Nr. 2, März 1981, Seiten 79-83, Old Woking, GB; D.A. PUCKNELL et al.: "TE design processes for successive-approximation A/D convertor registers"
- CONFERENCE RECORD, 11TH ASILOMAR CONFERENCE ON CIRCUITS, SYSTEMS AND COMPUTERS, Pacific Grove, California, 7.-9. November 1977, Seiten 45-49, IEEE, New York, US; H.T. RUSSELL: "An improved successive-approximation register design for use in monolithic A/D converters"
- COMPUTER DESIGN, Band 11, Nr. 7, Juli 1972, Seiten 81-86, Concord, US; T.O. ANDERSON: "Optimum control logic for successive approximation A-D converters"
- RADIO FERNSEHEN ELEKTRONIK, Band 35, Nr. 9, 1986, Seiten 579-580, Ost-Berlin, DD; H. JUNGNICKEL: "Integriertes sukzessives 12-bit-Approximationsregister K 155 HP 17"

## Beschreibung

Die Erfindung betrifft ein sukzessives Approximations-Register nach dem Oberbegriff des Patentanspruchs 1.

Derartige Register werden vor allem in Analog-Digital-Umsetzern nach dem Wägeverfahren eingesetzt. Bei diesem Umsetzerverfahren werden die Registerstellen sukzessive, beginnend mit dem höchstwertigen Bit, auf logisches Einspotential gesetzt und geprüft, ob die Eingangsspannung höher als die Spannung ist, die dem digitalen Wort des sukzessiven Approximations-Registers entspricht. Ist das der Fall, bleibt es gesetzt, andernfalls wird es gelöscht. Dieser Wägevorgang wird für jedes Bit wiederholt, bis am Ende der Konversionsphase auch das niederwertigste Bit feststeht.

Die Analog-Digital-Umsetzung wird über das sukzessive Approximations-Register gesteuert. Ein derartiges Register ist beispielsweise in dem Buch "Halbleiter-Schaltungstechnik" von U. Tietze und Ch. Schenk, 7., überarbeitete Auflage, Springer-Verlag, Berlin, Heidelberg, New York, 1985, S. 767, insbesondere S. 769 ff beschrieben.

Das sukzessive Approximations Register enthält ein Schieberegister, in dem ein logisches Einspotential bei jedem Takt um eine Position weitergeschoben wird. Dadurch werden die Bits der Reihe nach versuchsweise auf logisches Einspotential gesetzt. Das jeweilige Wägeresultat wird in weiteren Speicherelementen gespeichert, in die der betreffende Komparatorzustand eingelesen wird. Dabei wird nur dasjenige Speicherelement freigegeben, dessen zugehöriges Bit gerade getestet wird. Für die Umwandlungsphase wird also, bezogen auf die Anzahl der Bits, die doppelte Anzahl an Speicherelementen benötigt.

Nach der Festlegung des niederwertigsten Bits wird in der Regel ein weiteres Speicherelement des Schieberegisters gesetzt, damit angezeigt wird, daß die Konversionsphase abgeschlossen ist.

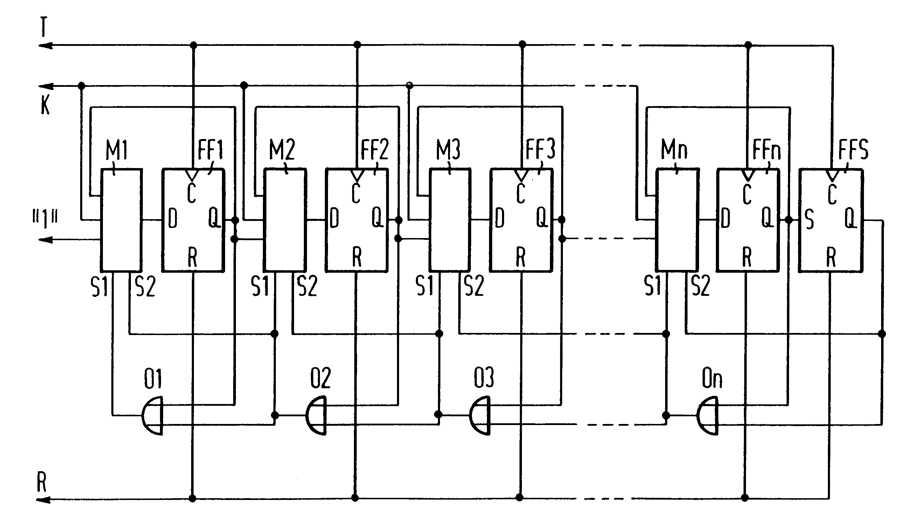

Aus der Veröffentlichung H.T. Russell: "An improved successive-approximation register design for use in monolithic A/D converters", Conference Record, 11th Asilomar Conference on Circuits, Systems and Computers, Pacific Grove, California, 7.-9. November 1977, Seiten 45-49 ist ein sukzessives Approximations-Register bekannt, das gemäß Fig. 4 n Speicherelemente aufweist. Die Speicherelemente sind nicht hintereinander geschaltet und werden von einer Logikschaltung gesteuert. Die Speicherelemente werden getaktet, bis das Vergleichsergebnis gespeichert ist, danach werden die Takteingänge abgeschaltet. Während der Wandlungsphase arbeitet die Schaltung deshalb nur teilweise im Synchronbetrieb, was insbesondere im Hinblick auf Verzögerungszeiten im Rahmen der Gesamtschaltung nachteilig ist. Darüberhinaus erfordert die Schaltung vergleichsweise viele Logikelemente für die Steuerung der Speicherelemente.

Der Erfindung liegt die Aufgabe zugrunde, ein sukzessives Approximations-Register anzugeben, das mit einer möglichst geringen Anzahl Speicherelementen auskommt, speziell für eine integrierte MOS-Technik einfach implementierbar ist und einen Vollsynchronbetrieb während der gesamten Wandlungsphase ermöglicht.

Diese Aufgabe wird bei einem sukzessiven Approximations-Register der eingangs genannten Art erfindungsgemäß durch die Merkmale des kennzeichnenden Teils des Patentanspruchs 1 gelöst.

Das erfindungsgemäße Register besitzt den Vorteil, daß sich Multiplexer in integrierter MOS-Technik in sehr einfacher Weise aus Transfergattern aufbauen lassen.

Weitere Ausgestaltungen der Erfindung sind in Unteransprüchen gekennzeichnet.

Die Erfindung wird im folgenden anhand eines in der einzigen Figur der Zeichnung dargestellten Ausführungsbeispiels näher erläutert.

Gemäß der Figur enthält das erfindungsgemäße sukzessive Approximations-Register als Speicherelemente n Flip-Flops FF1 und FFn, die jeweils entsprechend den n Bits des zu wandelnden Wortes einer dualen Wichtung entsprechen. Die Flip-Flops FF1 bis FFn sind als D-Flip-Flops ausgeführt, bei denen mit jedem Taktimpuls eine am Dateneingang D liegende digitale Information an den Datenausgang Q übernommen wird. Alle Flip-Flops FF1 bis FFn sind über jeweils den Eingang C taktgesteuert und können über jeweils den Eingang R rückgesetzt werden.

Jedem Flip-Flop FF1 bis FFn ist dateneingangsseitig ein Multiplexer M1 bis Mn mit jeweils zwei Steuereingängen S1 und S2 und jeweils drei Dateneingängen zugeordnet. Abhängig von den logischen Potentialen an den Steuereingängen können die Dateneingänge des Multiplexers wahlweise an den Ausgang bzw. den Eingang des nachfolgenden Flip-Flops durchgeschaltet werden. Gemäß der Figur dient der untere Dateneingang der Multiplexer als Schiebeeingang zum Schieben von Daten, der mittlere Dateineingang als Schreibeingang zum Einschreiben von Daten und der obere Dateneingang als Speichereingang zur Speicherung von Daten.

Der Schiebeeingang des Multiplexers M1 liegt auf logischem Einspotential, während die Schiebeeingänge der anderen Multiplexer am Datenausgang des jeweils vorgeordneten, einer höheren dualen Wichtung entsprechenden Flip-Flops angeschlossen sind. Alle Schreibeingänge der Multiplexer sind gemeinsam mit dem Ausgang eines Komparators K verbunden, der in dem Analog-Digital-Umsetzer eingesetzt wird. Die Speichereingänge der jeweiligen Multiplexer sind mit den Datenausgängen Q der jeweils zugeordneten Flip-Flops verbunden, so daß bei durchgeschaltetem Speichereingang das logische Potential am Datenausgang des jeweiligen Flip-Flops wieder auf den Dateneingang des Flip-Flops geführt wird.

Die Steuerung der Multiplexer erfolgt im Ausführungsbeispiel gemäß der Figur mit Hilfe von logischen ODER-Gliedern O1 bis On, wobei jedem Flip-Flop mit Multiplexer genau ein ODER-Glied zugeordnet ist. Der Ausgang jedes ODER-Gliedes steuert jeweils den Steuereingang S1 des zugeordneten und den Steuereingang S2 des der nächsthöheren Wichtung zugeordneten Multiplexers, z.B. der Ausgang des Logikgliedes O2 den Steuereingang S2 des Multiplexers M1 und den Steuereingang S1 des Multiplexers M2. Der Ausgang des Logikgliedes O1 ist entsprechend, da kein höherwertiges Flip-Flop existiert, nur mit dem Steuereingang S1 des Multiplexers M1 verbunden. Die Eingänge der logischen ODER-Glieder O1 bis On sind jeweils mit dem Datenausgang Q des zugeordneten Flip-Flops und mit dem Ausgang des ODER-Gliedes verbunden, das dem nächstniedriger gewichtetem Flip-Flop zugeordnet ist. So ist ein Eingang des Gliedes O1 mit dem Datenausgang Q des Flip-Flops FF1 und der zweite Eingang des Gliedes O1 mit dem Ausgang des Gliede O2 verbunden.

Der Steuereingang S2 des Multiplexers Mn und der nicht mit dem Datenausgang Q des Flip-Flops FFn verbundene Eingang des ODER-Gliedes On liegen auf gleichem Potential, das entweder das logische Nullpotential sein kann oder das ein Potential sein kann, das vom Ausgang eines dem Approximations-Registers nachgeschalteten Status-Flip-Flops FFS gesteuert wird. Gemäß der Figur ist das Status-Flip-Flop FFS eingangsseitig mit dem Ausgang Q des Flip-Flops FFn für das niederwertigste Bit verbunden, wobei das Flip-Flop FFS wie im Ausführungsbeispiel als RS-Flip-Flop ausgeführt sein kann, das seinen Ausgangszustand nicht ändert, wenn der Setzeingang S nach einem logischen Einspotential wieder ein Nullpotential annimmt.

Zur Beschreibung der Funktionsweise des sukzessiven Approximations-Registers sei angenommen, daß sämtliche Flip-Flops zu Beginn der Konversionsphase rückgesetzt sind. Das bedeutet, daß sämtliche Ausgänge Q auf logischem Nullpotential liegen und daß alle Multiplexer entsprechend der logischen OO-Postion der Steuereingänge S1 und S2 den Schiebeeingang durchgeschaltet haben. Damit wird das logische Einspotential am Schiebeeingang des Multiplexers M1 mit jedem Taktimpuls um eine Stelle bzw. um ein Flip-Flop weitergeschoben. Das Flip-Flop, in dem sich das durchgeschobene logische Einspotential befindet, schaltet über das zugeordnete logische ODER-Glied den Steuereingang S1 des zugeordneten Multiplexers auf Einspotential, so daß der Schreibeingang auf den Dateneingang des Flip-Flops durchgeschaltet wird und beim nächsten Takt das Ergebnis des Komparators K übernommen wird. Gleichzeitig befinden sich die Steuereingänge S1 und S2 der Multiplexer, die Flip-Flops mit höheren dualen Wertigkeiten zugeordnet sind, beide auf logischem Einspotential, so daß der Speichereingang des Multiplexers auf den Dateneingang des zugehörigen Flip-Flops durchgeschaltet ist und das Flip-Flop somit seinen Wert, der dem Wägeresultat des Analog-Digital-Umsetzers entspricht, bis zum Abschluß der Konversionsphase und gegebenenfalls länger speichert.

Allgemein gilt: Die logischen ODER-Glieder liegen ausgangsseitig dort auf logischem Einspotential, wo sich das durchgeschobene logische Einspotential des Multiplexers M1 gerade befindet oder befunden hat. Die Ausgänge der anderen ODER-Glieder liegen auf logischem Nullpotential.

Unter der Annahme, daß das Status-Flip-Flop FFS nicht vorgesehen ist, muß der Takt des erfindungsgemäßen sukzessiven Aproximations-Registers dann abgeschaltet werden, wenn das niederwertigste Flip-Flop FFn das Komparatorergebnis übernommen hat. Mit dem Status-Flip-Flop FFS dagegen wird dieses Flip-Flop von dem durchgeschobenen logischem Einspotential gesetzt und legt damit den Steuereingang S2 des Multiplexers Mn bzw. den Ausgang des Logikgliedes On unabhängig vom Wägeresultat des niederwertigsten Flip-Flops FFn auf logisches Einspotential, so daß auch dieses niederwertigste Flip-Flop FFn eingangsseitig mit dem Speichereingang des Multiplexers Mn verbunden ist.

Es liegt im Rahmen der Erfindung, daß die zur Steuerung der Multiplexer vorgesehenen Logikglieder auch aufwendiger ausgeführt werden können, wenn höhere Anforderungen an die Verarbeitungsgeschwindigkeit gestellt werden. Dabei kommen dann auch ODER-Glieder mit mehr als zwei Eingängen zum Einsatz. So ist es zum Beispiel möglich, daß ein Signal im ungüngstigsten Fall, statt wie im Ausführungsbeispiel alle ODER-Glieder, nur höchstens zwei ODER-Glieder sequentiell zu durchlaufen hat. Für eine derartige Carry-Look-Ahead-Schaltung sind allerdings in der Regel mehr Logikglieder erforderlich als im Ausführungsbeispiel.

Das erfindungsgemäße sukzessive Approximations-Register kann also mit einer Anzahl Speicherelemente, die der Anzahl der Bits entspricht, mit Hilfe der im integrierter MOS-Technik sehr einfach aufgebauten Multiplexer mit nur sehr wenigen Bauelementen die gestellten Aufgaben erfüllen, nämlich: Implementierung einer Ablaufsteuerung zur Bestimmung des gerade in der Durchführung befindlichen Konvertierungsschrittes, Verarbeiten des vom Analog-Teil bzw. Komparator gelieferten Resultats und Speicherung des Wägeresultats für den Rest der Konversion.

## Patentansprüche

1. Sukzessives Approximations-Register für einen Analog-Digital-Umsetzer nach dem Wägeverfahren mit der Bitbreite n, in dem n Speicherelemente (FF1 bis FFn) mit jeweils einem Dateneingang (D) und einem Datenausgang (Q) zum Weiterschieben eines logischen Einspotentials ("1") für jeden sukzessiven Wägeschritt sowie zum Einschreiben und Speichern des jeweiligen, von einem Komparator (K) ermittelten Wägeresultats vorgesehen sind, wobei die Speicherelemente taktgesteuert und jeweils dateneingangsseitig von Datenausgängen (Q) über Logikglieder (O1 bis On) gesteuert sind und entsprechend einer dual zugeordneten Wichtung hintereinander liegen,
dadurch gekennzeichnet,
daß den n Speicherelementen (FF1 bis FFn) jeweils dateneingangsseitig ein Multiplexer (M1, ...Mn) mit einem Schiebeeingang zum Schieben von Daten, einem Schreibeingang zum Einschreiben von Daten und einem Speichereingang zur Speicherung von Daten zugeordnet ist und jeder Multiplexer auf den Dateneingang (D) des zugehörigen Speicherelements durchgeschaltet werden kann, wobei
der Schiebeeingang des der höchsten Wichtung zugeordneten Multiplexers (M1) auf logischem Einspotential liegt, die Schiebeeingänge der anderen Multiplexer (M2 bis Mn) mit dem Datenausgang des jeweils vorhergehenden, einer höheren Wichtung zugeordneten Speicherelements verbunden sind, die Schreibeingänge der Multiplexer (M1 bis Mn) gemeinsam an den Komparator (K) angeschlossen sind und die Speichereingänge der Multiplexer jeweils an dem Datenausgang (Q) des zugeordneten Speicherelements liegen, und wobei
die Logikglieder (O1 bis On) zur Steuerung der Multiplexer (M1 bis Mn) von den Datenausgängen (Q) der n Speicherelemente aus so angeordnet sind, daß sukzessive das logische Einspotential am Schiebeeingang des der höchsten Wichtung zugeordneten Multiplexers zu den einer niedrigeren Wichtung zugeordneten Speicherelementen und Multiplexern durchgeschaltet wird, wozu bei den Multiplexern, die gegenüber dem jeweils der niedrigsten Wichtung zugeordneten Speicherelement mit logischem Einspotential am Datenausgang einer niedrigeren Wichtung zugeordnet sind, die Schiebeeingänge durchgeschaltet sind, wobei der dem jeweils der niedrigsten Wichtung zugeordneten Speicherelement mit logischem Einspotential am Datenausgang zugeordnete Multiplexer den Schreibeingang durchgeschaltet hat, und wobei bei den Multiplexern, die gegenüber dem jeweils der niedrigsten Wichtung zugeordneten Speicherelement mit logischem Einspotential am Datenausgang einer höheren Wichtung zugeordnet sind, die Speichereingänge durchgeschaltet sind.

2. Register nach Anspruch 1,
dadurch gekennzeichnet,
daß die Logikglieder ODER-Glieder (O1 bis On) sind und in ihrer Anzahl mindestens der Anzahl der Speicherelemente entsprechen.

3. Register nach Anspruch 2,
dadurch gekennzeichnet,
daß ein Steuereingang (S2) desjenigen Multiplexers (Mn) und ein Eingang des ODER-Gliedes (On), die dem der niedrigsten Wichtung zugeordneten Speicherelement (FFn) zuzuordnen sind, auf logischem Nullpotential liegen.

4. Register nach Anspruch 2,
dadurch gekennzeichnet,
daß dem der niedrigsten Wichtung zugeordneten Speicherelement (FFn) ein weiteres Speicherelement (FFS) nachgeschaltet ist, das einen Steuereingang (S2) desjenigen Multiplexers (Mn) und einen Eingang des ODER-Gliedes (On) steuert, die dem der niedrigsten Wichtung zugeordneten Speicherelement (FFn) zuzuordnen sind.

5. Register nach Anspruch 3 oder 4,
dadurch gekennzeichnet,
daß jedem Speicherelement mit Multiplexer (FF1 bis FFn , M1 bis Mn) nur ein ODER-Glied (O1 bis On) zugeordnet ist, dessen Ausgang jeweils einen Steuereingang (S1, S2) des zugeordneten und des der nächsthöheren Wichtung zugeordneten Multiplexers steuert und dessen Eingänge jeweils mit dem Datenausgang (Q) des zugeordneten Speicherelements und mit dem Ausgang des ODER-Gliedes verbunden sind, das dem der nächstniedrigeren Wichtung zugeordneten Speicherelement zugeordnet ist.

6. Register nach Anspruch 3 oder 4,
dadurch gekennzeichnet,
daß die Logikglieder zur Steuerung der Multiplexer (M1 bis Mn) als Carry-Look-Ahead-Schaltung ausgeführt sind.

## Claims

1. Successive approximation register for an analog-digital converter operating according to the iteration method and having the bit width n, in which n memory elements (FF1 to FFn) each having one data input (D) and one data output (Q) are provided for shifting onward a logical one potential ("1") for each successive iterative step as well as for writing in and storing the respective iteration result determined by a comparator (K), in which the memory elements are clock-controlled and are controlled in each case on the data input side by data outputs (Q) via logic elements (O1 to On) and lie in series in accordance with a dual weighting assigned, characterized in that assigned to the n memory elements (FF1 to FFn) in each case on the data input side are a multiplexer (M1, ... Mn) having a shift input for shifting data, a write input for writing in data and a store input for storing data, and each multiplexer can be switched through to the data input (D) of the associated memory element, in which the shift input of the multiplexer (M1) assigned to the highest weighting is at logical one potential, the shift inputs of the other multiplexers (M2 to Mn) are connected to the data output of the respective preceding memory element assigned to a higher weighting, the write inputs of the multiplexers (M1 to Mn) are connected jointly to the comparator (K), and the store inputs of the multiplexers are connected in each case to the data output (Q) of the assigned memory element, and in which, for controlling the multiplexers (M1 to Mn) from the data outputs (Q) of the n memory elements, the logic elements (O1 to On) are arranged in such a way that the logical one potential at the shift input of the multiplexer assigned to the highest weighting is successively switched through to the memory elements and multiplexers assigned to a lower weighting, for which purpose the shift inputs are switched through in the case of the multiplexers that are assigned to a lower weighting in comparison with the memory element which has logical one potential at the data output and is assigned to the lowest weighting in each case, in which the multiplexer that is assigned to the memory element which has logical one potential at the data output and is assigned to the lowest weighting in each case has switched through the write input, and in which the store inputs are switched through in the case of the multiplexers that are assigned to a higher weighting in comparison with the memory element which has logical one potential at the data output and is assigned to the lowest weighting in each case.

2. Register according to Claim 1, characterized in that the logic elements are OR elements (O1 to On), the number of which corresponds at least to the number of memory elements.

3. Register according to Claim 2, characterized in that one control input (S2) of the particular multiplexer (Mn) and one input of the OR element (On) which are associated with the memory element (FFn) assigned to the lowest weighting are at logical zero potential.

4. Register according to Claim 2, characterized in that connected downstream of the memory element (FFn) assigned to the lowest weighting is a further memory element (FFS) which controls one control input (S2) of the particular multiplexer (Mn) and one input of the OR element (On) which are associated with the memory element (FFn) assigned to the lowest weighting.

5. Register according to Claim 3 or 4, characterized in that only one OR element (O1 to On) is assigned to each memory element with multiplexer (FF1 to FFn, M1 to Mn), the output of which OR element controls in each case a control input (S1, S2) of the assigned multiplexer and of the multiplexer assigned to the next-higher weighting, and the inputs of which are connected in each case to the data output (Q) of the assigned memory element and to the output of the OR element which is assigned to the memory element assigned to the next-lower weighting.

6. Register according to Claim 3 or 4, characterized in that the logic elements for controlling the multiplexers (M1 to Mn) are designed as a carry-look-ahead circuit.

## Revendications

1. Registre à approximations successives pour un convertisseur analogique/numérique opérant selon le procédé de pondération, possédant une largeur de n bits et dans lequel il est prévu n éléments de mémoire (FF1 à FFn) comportant chacun une entrée de données (D) et une sortie de données (Q) pour faire avancer un potentiel logique ("1") pour chaque pas successif de pondération ainsi que pour l'enregistrement et la mémorisation du résultat respectif de pondération, déterminé par un comparateur (K), les éléments de mémoire étant commandés de façon cadencée, étant respectivement commandés, sur le côté d'entrée des données, par des sorties de données (Q), par l'intermédiaire de circuits logiques (01 à 0n) et étant disposés les uns derrière les autres conformément à une pondération associée binaire,
caractérisé par le fait
qu'à chacun des n éléments de mémoire (FF1 à FFn) est associé, respectivement, sur le côté entrée des données, un multiplexeur (M1,...Mn) comportant une entrée de décalage pour le décalage de données, une entrée d'enregistrement pour l'enregistrement de données et une entrée de mémoire pour la mémorisation de données, et que chaque multiplexeur peut être connecté directement à l'entrée de données (D) de l'élément de mémoire associé, et dans lequel
l'entrée de décalage du multiplexeur (M1) associé à la pondération maximale est placée au potentiel un logique, les entrées de décalage des autres multiplexeurs (M2 à Mn) sont reliées à la sortie de données de l'élément de mémoire respectivement précédent, qui est associé à une pondération plus élevée, les entrées d'enregistrement des multiplexeurs (M1 à Mn) sont raccordées en commun au comparateur (K) et les entrées de mémoire des multiplexeurs sont connectées respectivement à la sortie de données (Q) de l'élément de mémoire associé, et dans lequel
les circuits logiques (01 à 0n) servant à commander les multiplexeurs (M1 à Mn) à partir des sorties de données (Q) des n éléments de mémoire sont disposés de telle sorte que successivement le potentiel un logique à l'entrée de décalage du multiplexeur associé à la pondération maximale est transmis aux éléments de mémoire et multiplexeur, associés à une pondération plus faible, auquel cas, à cet effet, les entrées de décalage sont interconnectées, dans le cas des multiplexeurs qui sont associés à une pondération plus faible que celle de l'élément de mémoire, qui est associé à la pondération la plus faible et délivre un potentiel un logique à la sortie de données,
et dans lequel l'élément de mémoire, qui est associé respectivement à la pondération la plus faible et délivre le potentiel un logique de la sortie de données, a interconnecté l'entrée d'enregistrement, et dans lequel les entrées de mémoire sont interconnectées directement dans le cas des multiplexeurs, qui sont associés à une pondération plus élevée que l'élément de mémoire respectivement associé à la pondération la plus faible et délivre un potentiel un logique à la sortie de données.

2. Registre suivant la revendication 1, caractérisé par le fait que les circuits logiques sont des circuits OU (O1 à On) et que leur nombre correspond au moins au nombre des éléments de mémoire.

3. Registre suivant la revendication 2, caractérisé par le fait qu'une entrée de commande (S2) du multiplexeur (Mn) et une entrée du circuit OU (On), qui doivent être associées à l'élément de mémoire (FFn) associé à la pondération minimale, sont placées au potentiel zéro logique.

4. Registre suivant la revendication 2, caractérisé en ce qu'en aval de l'élément de mémoire (FFn), associé à la pondération la plus faible, est branché un autre élément de mémoire (FFS), qui commande une entrée de commande (S2) du multiplexeur (Mn) et une entrée du circuit OU (On), qui doivent être associées à l'élément de mémoire (FFn) associé à la pondération la plus faible.

5. Registre suivant la revendication 3 ou 4, caractérisé par le fait qu'à chaque élément de mémoire comportant un multiplexeur (FF1 à FFn, M1 à Mn) est associé uniquement un circuit OU (O1 à On), dont la sortie commande une entrée de commande (S1,S2) du multiplexeur associé et du multiplexeur associé à la pondération immédiatement supérieure et dont les entrées sont reliées respectivement à la sortie de données (Q) de l'élément de mémoire associé à la sortie du circuit OU, qui est associé à l'élément de mémoire associé à la pondération immédiatement inférieure.

6. Registre suivant la revendication 3 ou 4, caractérisé par le fait que les circuits logiques servant à commander les multiplexeurs (M1 à Mn) sont réalisés sous la forme d'un circuit Carry-Look-Ahead.
